Europäisches Patentamt

European Patent Office

Office européen des brevets

(19)

(11) Publication number: **0 318 163**
**A2**

# EUROPEAN PATENT APPLICATION

(21) Application number: 88310198.2

(51) Int. Cl.⁴: **H03K 3/037 , H03K 3/356**

(22) Date of filing: **31.10.88**

(30) Priority: **20.11.87 US 123498**

(43) Date of publication of application:
**31.05.89 Bulletin 89/22**

(84) Designated Contracting States:
**DE FR GB**

(71) Applicant: **International Business Machines Corporation**
**Old Orchard Road**
**Armonk, N.Y. 10504(US)**

(72) Inventor: **Chung, Paul Wingshing**
**6943 Sessions Dr.**
**San Jose, CA 95119(US)**
Inventor: **Wang, Niantsu Nathanuial**
**824 Bolton Dr.**
**Milpitas, CA 95035(US)**

(74) Representative: **Hobbs, Francis John**
**IBM United Kingdom Limited Intellectual**
**Property Department Hursley Park**
**Winchester Hampshire SO21 2JN(GB)**

(54) **An edge-triggered latch and production of an edge-triggered signal therefor.**

(57) An edge-triggered latch comprises a dynamic sensing means ($T_{15}$ to $T_{18}$) for detecting the voltage level of the data signal and a dynamic buffer (DL) for amplifying the detected voltage level into one of two logic levels recognizable by a static latch (SL) wherein the sampled result is stored.

*Fig. 1*

EP 0 318 163 A2

## AN EDGE-TRIGGERED LATCH AND PRODUCTION OF AN EDGE-TRIGGERED SIGNAL THEREFOR

This invention relates to an edge-triggered latch and to the production of an edge-triggered signal therefor.

Edge-triggered latches have commonly been used in electronic systems for sampling externally generated signals. In most applications, such signals would arrive asynchronously with respect to the system clock which controls a system's internal operations. A signal input is usually sampled with the edge of the system clock which triggers a latch to register the state of the signal. Ideally, the input signal should be sampled only when it is in either one of two bistable states, each representing a binary value. Unfortunately, there often exists a high probability that, at any sampling instant, the signal level is at the metastable state of the latch, i.e. at a level where the state is indeterminable.

To lower the probability of metastability, conventional edge-triggered latches are required to have a setup time, which is the minimum duration in which the input signal has been settled in one of the bistable states before the occurrence of the sampling pulse. When high speed signal processing is required, however, an edge-triggered latch having low setup time and decreased metastability problem is desired.

U.S.-A- 4,227,699 discloses a latch circuit operable as a D-type edge trigger which is basically formed by combining two polarity latches with other logic circuits. Although the latch can conform to LSSD design rules, it nevertheless suffers from the long setup time and metastability problem.

The invention seeks to provide a way of reducing the setup time of an edge-triggered latch.

The invention provides, according to one aspect, an apparatus for producing an edge-triggered signal for use in an edge-triggered latch, comprising dynamic sensing means responsive to a trigger signal and a data signal for detecting the voltage level of the data signal; means for producing a timing pulse delayed with respect to the trigger signal; dynamic buffer means coupled to the dynamic sensing means for amplifying said detected voltage level; and means responsive to said pulse for gating the amplified detected voltage signal into one of two logic levels recognizable by an edge-triggered latch.

The invention also provides a method of producing an edge-triggered signal from a data signal and a trigger signal, for storage by an edge-triggered latch, comprising the steps of detecting the voltage level of the data signal using a dynamic sensing device; and using a dynamic buffer means for amplifying said detected voltage level; and gating the amplified detected voltage level into one of two logic levels recognizable by the latch.

The invention provides, according to another aspect, an edge-triggered latch comprising a static latch; a dynamic sensing means responsive to a trigger signal and a data signal for detecting the voltage level of the data signal; dynamic buffer means coupled to the dynamic sensing means for amplifying the detected voltage level into one of two logic levels recognizable by the static latch; and gating means coupled to the static latch and the dynamic buffer means for gating the output of the dynamic buffer means to the static latch between predetermined time windows.

How the invention can be carried out will now be described by way of example, with reference to the accompanying drawings, in which:-

Fig. 1 is a schematic diagram of one circuit embodying the invention; and

Fig. 2 is a schematic diagram of a circuit which generates a one-shot pulse from the rising edge of a clock signal.

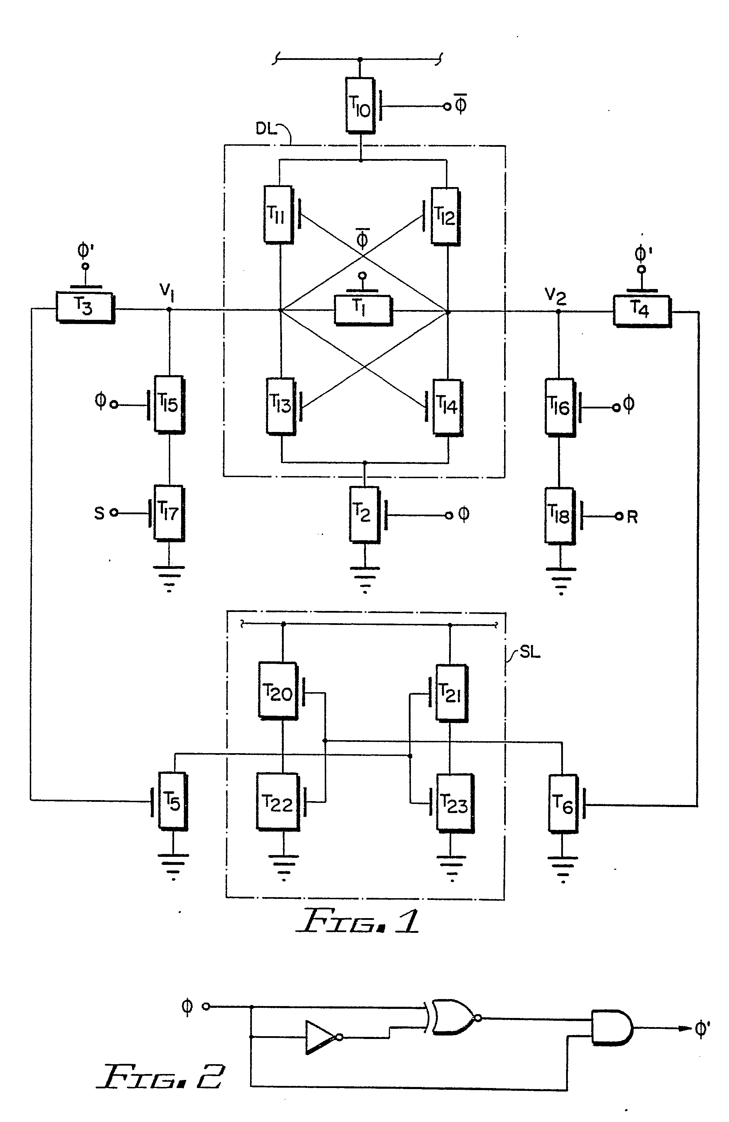

Referring to Fig. 1, a first dynamic buffer, comprising a first pair of cross-coupled p-channel Field Effect Transistors (FETs), $T_{11}$ and $T_{12}$, is connected between nodes $V_1$ and $V_2$. A dynamic buffer is characterized by its not being able to enter into a metastable state. A second dynamic buffer, comprising a second pair of cross-coupled n-channel FETs, $T_{13}$ and $T_{14}$, is also connected between nodes $V_1$ and $V_2$ in parallel to the first dynamic buffer. The two dynamic buffers amplify voltage signals across these two nodes into full logic level.

Both $T_{11}$ and $T_{12}$ are enabled by the negative phase of sampling clock $\emptyset$ (i.e. $\overline{\emptyset}$) which controls the gate of p-channel FET $T_{10}$. Both $T_{13}$ and $T_{14}$ are enabled by the positive phase of the sampling clock $\emptyset$ which controls the gate of n-channel FET $T_2$.

A dynamic sensing device is connected to node $V_1$ for receiving a differential input of the signal to be sampled. This dynamic device comprises two n-channel FETs, $T_{16}$ and $T_{18}$, connected in series. Similarly, another dynamic sensing device is connected at node $V_2$ for receiving the opposite differential input of the signal to be sampled. This dynamic device comprises two serially connected n-channel FETs, $T_{15}$ and $T_{17}$.

Between nodes $V_1$ and $V_2$ is a precharging FET, $T_1$, which provides a path between these nodes. When $T_1$ conducts, nodes $V_1$ and $V_2$ connect and their voltage levels are equalized, thereby allowing them to switch faster. The gate of $T_1$ is controlled by the negative phase of the sampling

clock $\emptyset$ (i.e. $\emptyset$).

Each of the differential outputs of the dynamic buffer DL is transferred to respective input devices, $T_5$ and $T_6$, of static latch SL which consists of n-channel FETs $T_{20}$, $T_{21}$, $T_{22}$, and $T_{23}$. The differential output at node $V_1$ is transferred to $T_5$ via a n-channel FET $T_3$. The differential output at node $V_2$ is transferred to $T_6$ via a p-channel FET $T_4$. The gates of both $T_3$ and $T_4$ are controlled by a clock $\emptyset'$ which is a time delayed pulse of $\emptyset$. One method of generating $\emptyset'$ is by delaying the rising edge (the triggering edge) of clock $\emptyset$. A circuit for accomplishing such purpose is illustrated in Fig. 2.

Let $T = 0$ be the sampling time. Before $T = 0$, clock $\emptyset$ would be "low" and its inverted clock $\emptyset$ would be "high". Devices $T_{10}$ and $T_2$ are thereby cut off while device $T_1$ opens. The opening of device $T_1$ equalizes node voltages $V_1$ and $V_2$ at $T < 0$. Moreover, since devices $T_3$ and $T_4$ are cut off, static latch SL is not affected.

At the sampling instant, $T = 0$, $\emptyset$ goes up. Precharging device $T_1$ is disabled. The differential inputs of the signal being sampled, received at $T_{17}$ and $T_{18}$, are gated by devices $T_{15}$ and $T_{16}$ to nodes $V_1$ and $V_2$. Devices $T_{10}$ and $T_2$ set the latch quickly. The output at nodes $V_1$ and $V_2$ are then sent to input devices, $T_5$ and $T_6$ respectively, of the static latch SL. The pass gates $T_3$ and $T_4$ are controlled by $\emptyset'$ which goes up with $\emptyset$ at a delay so that the dynamic latch can be set without too much load. Also, $\emptyset'$ is generated as a one shot clock following the rising edge of $\emptyset$ so that the output of the static latch SL stays constant until the next trigger time.

Although the circuit has been described as using a particular semiconductor device type, other devices having the same characteristics can be used. For example, p-channel FETs can be replaced by n-channel FETs in the circuits if corresponding changes in other parts of the circuits are made.

## Claims

1. An apparatus for producing an edge-triggered signal for use in an edge-triggered latch, comprising:
dynamic sensing means ($TH_{15}$ to $T_{18}$) responsive to a trigger signal and a data signal for detecting the voltage level of the data signal;
means for producing a timing pulse ($\emptyset'$) delayed with respect to the trigger signal;
dynamic buffer means (DL) coupled to the dynamic sensing means for amplifying said detected voltage level; and
means ($T_3$, $T_4$) responsive to said pulse for gating the amplified detected voltage signal into one of two logic levels recognizable by an edge-triggered latch.

2. An apparatus as claimed in claim 1, wherein the dynamic buffer means comprises means for precharging ($T_1$) the sensing means to reduce the setup time of the sensing means.

3. An apparatus as claimed in claim 1 or claim 2, wherein the dynamic buffer means comprises at least one pair of cross-coupled FET devices.

4. An apparatus as claimed in any preceding claim, wherein the sensing means comprises at least two FETs connected in series.

5. An edge-triggered latch comprising:
a static latch (SL);
a dynamic sensing means ($T_{15}$ to $T_{18}$) responsive to a trigger signal and a data signal for detecting the voltage level of the data signal;
dynamic buffer means (DL) coupled to the dynamic sensing means for amplifying the detected voltage level into one of two logic levels recognizable by the static latch; and
gating means ($T_3$, $T_4$) coupled to the static latch and the dynamic buffer means for gating the output of the dynamic buffer means to the static latch between predetermined time windows.

6. An edge-triggered latch as claimed in claim 5, further comprising means for precharging and equalizing the dynamic sensing means ($T_1$) to reduce the setup time between the trigger signal and the data signal.

7. An edge-triggered latch as claimed in claim 5 or claim 6, wherein the dynamic buffer means comprises a pair of cross-coupled p-channel FET devices and a pair of cross-coupled n-channel FET devices.

8. An edge-triggered latch as claimed in claim 5 or claim 6, wherein the dynamic sensing means comprises at least two FETs of the same channel type connected in series.

9. An apparatus as claimed in claim 1, wherein there are two nodes, each node connected to the dynamic buffer means, and to a respective sensing means, the dynamic buffer means comprising means operative in one state to precharge and equalize the voltage level at said nodes for reducing switching time when the dynamic buffer means is operative in its other state to amplify said detected voltage level as detected by one of the sensing means.

10. A method of producing an edge-triggered signal from a data signal and a trigger signal, for storage by an edge-triggered latch, comprising the steps of:
detecting the voltage level of the data signal using a dynamic sensing device; and
using a dynamic buffer means for amplifying said detected voltage level; and

gating the amplified detected voltage level into one of two logic levels recognizable by the latch.

11. A method as claimed in claim 10, comprising the further steps of precharging and equalizing the voltage level at two nodes connected to the dynamic sensing device to reduce the setup time between the trigger signal and the data signal.

12. A method as claimed in claim 10 or claim 11, wherein during the amplifying step, the voltage level at one node is detected and amplified relative to that of the other node, and

during the gating step, the voltages at both nodes are gated to the latch as differential inputs.

Fig. 1

Fig. 2